# FASCICULE DE BREVET EUROPEEN

(11) **EP 0 930 813 B1**
(45) Date de publication et mention de la délivrance du brevet: **11.09.2002**
(21) Numéro de dépôt: 99400051.1
(22) Date de dépôt: 11.01.1999
(51) Int. Cl.: H05K 5/00, F16B 21/07

(54) **Boîtier, en particulier pour bloc autonome d'éclairage de sécurité**
Gehäuse, insbesondere für autonome Notbeleuchtungseinheit
Casing, especialy for safety lighting block

(30) Priorité: 14.01.1998 FR 9800299
(43) Date de publication de la demande: 21.07.1999
(73) Titulaire: LEGRAND, F-87000 Limoges (FR); LEGRAND SNC, F-87000 Limoges (FR)
(72) Inventeur: Daubisse, Laurent, 24630 Jumilhac le Grand (FR); Pourieux, Nicolas, 87270 Couzeix (FR); Goudal, Jean-Paul, 87000 Limoges (FR)
(74) Mandataire: CABINET BONNET-THIRION

(56) Documents cités:
- EP-A- 0 409 347
- DE-A- 3 346 243
- "FIXTURE FOR INSTALLING AND REMOVING CIRCUIT CARD COVERS" IBM TECHNICAL DISCLOSURE BULLETIN, vol. 31, no. 6, novembre 1988, pages 407-409, XP000023416

## Description

La présente invention concerne d'une manière générale les boîtiers du genre comportant deux éléments emboîtable l'un sur l'autre, l'un formant par exemple un socle tandis que l'autre forme un couvercle rapporté de manière amovible sur un tel socle, avec, intervenant, entre ces deux éléments, pour leur solidarisation relative l'un à l'autre au moins un dispositif de verrouillage débrayable.

Elle vise plus particulièrement le cas où, pour satisfaire aux dispositions normative en vigueur dans le domaine concerné, l'ouverture d'un tel boîtier, c'est-à-dire la dépose de son couvercle par rapport à son socle, ne doit pouvoir se faire qu'à l'aide d'un quelconque outil, tel que par exemple un outil propre à faire levier, comme la lame d'un tournevis.

On connaît ainsi du document EP A 409 347 un boîtier comprenant un support et un socle, où le support comporte un dispositif d'accouplement comprenant une patte déformable dont un cran est adapté à coopérer avec une butée d'une bride portée par le sodé. Ce dispositif d'accouplement agit à la manière d'une serrure de porte dont la patte formerait le pêne, tandis que la bride du socle formerait la gâche correspondante. Pour séparer le socle du support, on agit sur la patte déformable avec la lame d'un tournevis.

Cela est aussi le cas, par exemple, pour certains appareils électriques, et, notamment, pour certains luminaire, tels que, par exemple, les blocs autonomes d'éclairage de sécurité.

Le plus souvent, à ce jour, le dispositif de verrouillage intervenant entre le couvercle et le socle du boîtier d'un tel bloc autonome d'éclairage de sécurité met en oeuvre au moins une pièce intermédiaire, en l'espèce une griffe, distincte à la fois de l'un et de l'autre de ces deux éléments.

De par son coût propre de fabrication et des difficultés de montage qu'elle induit inévitablement, cette pièce intermédiaire n'est pas sans influer de manière non négligeable sur le coût de l'ensemble.

En outre, deux dispositifs de verrouillage étant usuellement prévus en positions diamétralement opposées l'un par rapport à l'autre, il est nécessaire, à la dépose, d'intervenir simultanément sur chacun d'eux pour pouvoir dégager le couvercle du socle, ce qui complique les opérations.

Dans la demande de brevet allemand N° 39 29 768, il est décrit un dispositif de verrouillage, qui, d'une part, est intégré au boîtier, ses constituants faisant corps avec l'un ou l'autre des éléments constitutifs de celui-ci, ce qui permet de les faire venir de moulage avec ces derniers, et qui, d'autre part, peut être individuellement désactivé de manière temporaire, ce qui permet d'intervenir successivement dans ce sens sur chacun des dispositifs de verrouillage présents, et, ensuite, de dégager très simplement et très facilement l'un de l'autre les deux éléments constitutifs du boîtier.

Plus précisément, il est décrit, dans cette demande de brevet allemand, un boîtier comportant deux éléments emboîtables l'un sur l'autre, l'un quelconque de ces éléments, dit ci-après par simple commodité premier élément, comportant, pour la constitution d'un dispositif de verrouillage, au moins une patte d'encliquetage, qui, sensiblement transversalement par rapport à la direction d'emboîtement de l'ensemble, est munie d'un cran de verrouillage, tandis que l'autre de ces éléments, dit ci-après par simple commodité deuxième élément, comporte, d'une part, un cran de verrouillage, qui, pour coopération en crochetage avec le cran de verrouillage du premier élément, s'étend comme celui-ci sensiblement transversalement par rapport à la direction d'emboîtement, et, d'autre part, au moins une patte d'encliquetage, qui, pour le maintien de la patte d'encliquetage du premier élément dans une configuration déformée de déverrouillage pour laquelle son cran de verrouillage est à l'écart du trajet du cran de verrouillage du deuxième élément, comporte, sensiblement parallèlement à la direction d'emboîtement, un épaulement de retenue.

Ainsi, il suffit d'agir en poussée sur la patte d'encliquetage du premier élément, pour que, s'engageant derrière l'épaulement de retenue du deuxième élément, elle soit maintenue temporairement dans une configuration de déverrouillage autorisant le désengagement l'un par rapport à l'autre de ces deux éléments.

Mais, en pratique, dans cette demande de brevet allemand, le cran de verrouillage du deuxième élément est fixe, en étant rigidement lié à ce deuxième élément.

Conjointement, la direction de pivotement autour de laquelle la patte d'encliquetage de ce même deuxième élément est élastiquement déformable est sensiblement parallèle à la direction d'emboîtement.

Il résulte, globalement, de l'ensemble, que le dispositif de verrouillage correspondant a inévitablement un encombrement non négligeable transversalement par rapport à la direction d'emboîtement, notamment pour que la patte d'encliquetage du deuxième élément portant l'épaulement de retenue ait une longueur suffisante pour satisfaire dans de bonnes conditions à l'effacement élastique dont elle est temporairement l'objet au déverrouillage.

Si, comme en l'espèce, ce dispositif de verrouillage intervient à l'intérieur du boîtier, il empiète donc de manière non négligeable sur le volume utile de celui-ci.

Si, en variante, il devait intervenir à l'extérieur du boîtier, il ferait également une saillie non négligeable sur celui-ci, ce qui augmenterait d'autant l'encombrement externe hors tout de ce boîtier, et ce qui le rendrait vulnérable aux chocs.

La présente invention a d'une manière générale pour objet une disposition permettant d'éviter ces inconvénients.

De manière plus précise, elle a pour objet un boîtier comportant deux éléments emboîtables l'un sur l'autre suivant une direction d'emboîtement, à savoir :
- un premier élément comportant un moyen de verrouillage s'étendant sensiblement transversalement par rapport à la direction d'emboîtement, et un deuxième élément comportant au moins une patte d'encliquetage munie d'au moins un cran de verrouillage s'étendant sensiblement transversalement par rapport à la direction d'emboîtement et adapté à coopérer en crochetage avec le moyen de verrouillage du premier élément, la patte d'encliquetage du deuxième élément étant élastiquement déformable autour d'une direction de pivotement orthogonale à la direction d'emboîtement, où le dit moyen de verrouillage est un cran de verrouillage appartenant à une patte d'encliquetage apte à adopter une configuration déformée de déverrouillage dans laquelle son cran de verrouillage est à l'écart du trajet du cran de verrouillage de la patte d'encliquetage du deuxième élément, la patte d'encliquetage du deuxième élément comportant un épaulement de retenue apte à maintenir la patte d'encliquetage du premier élément dans sa configuration déformée de déverrouillage.

Ainsi, au lieu d'être disjoint de sa patte d'encliquetage, le cran de verrouillage du deuxième éléments est porté par cette patte d'encliquetage, et, de ce fait, celle-ci porte, à la fois, ce cran de verrouillage et d'épaulement de retenue nécessaire à la désactivation de l'ensemble, au bénéfice d'une plus grande compacité pour cet ensemble.

Grâce à une telle disposition, l'encombrement de l'ensemble transversalement par rapport à la direction d'emboîtement est particulièrement réduit puisque, en pratique, il se résume, pour l'essentiel, à l'épaisseur même des pattes d'encliquetage en jeu, en sorte que, lorsque, comme en l'espèce, le dispositif de verrouillage correspondant intervient préférentiellement à l'extérieur du boîtier, il ne fait avantageusement qu'une saillie très modérée sur celui-ci.

Plus précisément, si l'on fait volontairement abstraction de leur épaisseur, les pattes d'encliquetage en jeu s'étendent, suivant l'invention, dans un même plan, et, suivant une caractéristique de l'invention, elles interviennent de manière bidirectionnelle dans ce plan, dans une première direction pour le verrouillage de l'ensemble, et dans une deuxième direction orthogonale à la précédente pour son déverrouillage.

Les caractéristiques et avantages de l'invention ressortiront d'ailleurs de la description qui va suivre, à titre d'exemple, en référence aux dessins schématiques annexés sur lesquels :
- la figure 1 est une vue en perspective d'un boîtier suivant l'invention ;
- la figure 2 reprend, à l'échelle supérieure, le détail de la figure 1, qui, repéré par un encart II sur cette figure 1, concerne l'un des dispositifs de verrouillage dont est équipé ce boîtier, pour la configuration de verrouillage de celui-ci ;
- la figure 3, en correspondance, est une vue partielle de côté du boîtier suivant l'invention, suivant la flèche III de la figure 2 ;

la figure 4 en est une vue partielle en coupe, suivant la ligne IV-IV de la figure 3 ;
la figure 5 est, à échelle différente, une vue partielle en perspective du boîtier suivant l'invention, qui, déduite de celle de la figure 1, représente ce boîtier de manière éclatée ;
la figure 6 est une vue partielle en perspective qui, analogue à celte de la figure 5, illustre la fermeture de ce boîtier ;
la figure 7A est une vue partielle en perspective, qui, analogue à celle de la figure 2, illustre le déverrouillage de ce boîtier ;
la figure 7B est une vue partielle en perspective, qui, analogue, elle aussi, à celle de la figure 2, correspond à la configuration de déverrouillage du dispositif de verrouillage concerné ;
la figure 8 est une vue partielle en coupe qui, analogue, elle, à celle de la figure 4, correspond elle aussi à cette configuration de déverrouillage.

Ces figures illustrent, à titre d'exemple, l'application de l'invention à un luminaire 10, et, plus précisément, à un bloc autonome d'éclairage de sécurité.

Ce luminaire 10 ne relevant pas, par lui-même, de la présente invention, il ne sera pas décrit dans tous ses détails ici.

Seuls en seront décrits les éléments nécessaires à la compréhension de l'invention.

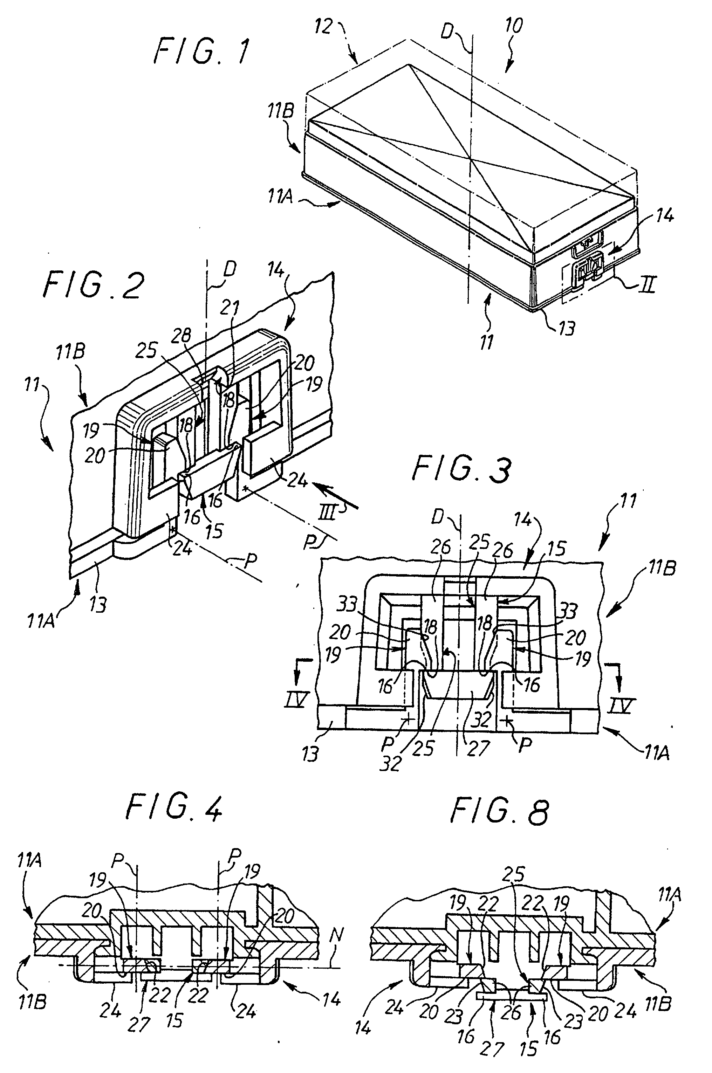

Il suffira d'indiquer à ce sujet que, pour le logement de divers composants techniques, ce luminaire 10 comporte un boîtier 11, que ce boîtier 11 porte, lui-même, en façade, d'autres composants techniques, qui ont volontairement été occultés par un X sur la figure 1, et que, dans la forme de réalisation représentée, et tel que schématisé en traits interrompus sur la figure 1, une verrine 12 se trouve emboîtée sur la partie supérieure de ce boîtier 11.

Dans la forme de réalisation représentée, le boîtier 11 a une forme globalement parallélépipédique.

De manière connue en soi, il comporte deux éléments 11A, 11B emboîtables l'un sur l'autre, à savoir, un élément 11A, qui, formant socle, est adapté à permettre de rapporter l'ensemble sur un quelconque support, non représenté, et qui présente pour ce faire une semelle 13, et, un élément 11B, qui, formant couvercle, est rapporté de manière amovible sur l'élément 11A.

Soit D, tel que schématisé en traits interrompus sur les figures 1, 2, 3 et 6, la direction d'emboîtement correspondante.

Cette direction d'emboîtement D est globalement perpendiculaire à la semelle 13 de l'élément 11A formant socle.

Les deux éléments 11A, 11B ainsi constitutifs du boîtier 11 sont solidarisés l'un à l'autre part au moins un dispositif de verrouillage 14.

En pratique, deux dispositifs de verrouillage 14 sont prévus, qui interviennent, chacun respectivement, sur les petits côtés du boîtier 11, dans la zone médiane de ceux-ci, en étant l'un et l'autre tout entier disposés à l'extérieur du boîtier 11, et dont un seul est visible sur les figures.

Ces deux dispositifs de verrouillage 14 sont identiques l'un à l'autre, et, de manière connue en soi, ils interviennent par encliquetage.

En pratique, pour la constitution d'un tel dispositif de verrouillage 14, l'un quelconque des éléments 11A, 11B constitutifs du boîtier 11, dit ici par simple commodité premier élément, comporte au moins une patte d'encliquetage 15, qui, sensiblement transversalement par rapport à la direction d'emboîtement D de l'ensemble, est munie d'au moins un cran de verrouillage 16, tandis que l'autre de ces éléments 11A, 11B, dit ici par simple commodité deuxième élément, comporte, d'une part, un cran de verrouillage 18, qui, pour coopération en crochetage avec le cran de verrouillage 16 du premier élément, s'étend comme celui-ci sensiblement transversalement par rapport à la direction d'emboîtement D, et, d'autre part, au moins une patte d'encliquetage 19, qui, pour le maintien de la patte d'encliquetage 15 du premier élément dans une configuration déformée de déverrouillage pour laquelle son cran de verrouillage 16 est à l'écart du trajet du cran de verrouillage 18 du deuxième élément, comporte, sensiblement parallèlement à la direction d'emboîtement D, un épaulement de retenue 20.

Dans la forme de réalisation représentée, l'élément portant la patte d'encliquetage 15 est l'élément 11B formant couvercle, et celui-ci sera donc maintenant désigné dans ce qui suit comme constituant effectivement le premier élément.

Corollairement, l'élément portant à la fois la patte d'encliquetage 19 et l'épaulement de retenue 20 est élément 11A formant socle, et celui-ci sera donc maintenant désigné dans ce qui suit comme constituant effectivement le deuxième élément.

Mais il va de soi que les rôles respectifs de ces deux éléments 11A, 11B peuvent être intervertis.

Suivant l'invention, le cran de verrouillage 18 du deuxième élément 11A est porté par sa patte d'encliquetage 19, et la direction de pivotement P autour de laquelle cette patte d'encliquetage 19 est élastiquement déformable est orthogonale à la direction d'emboîtement D.

Cette direction de pivotement P est schématisée en traits interrompus sur les figures 2, 4, 6 et 7A, et elle est repérée par sa trace sur la figure 3.

Dans la forme de réalisation représentée, le premier élément 11B ne comporte qu'une seule patte d'encliquetage 15, mais cette patte d'encliquetage 15 comporte, dos à dos, deux crans de verrouillage 16, et, en correspondance, le deuxième élément 11A comporte deux pattes d'encliquetage 19, qui portent chacune un cran de verrouillage 18, et dont chacune forme un épaulement de retenue 20.

Pour la configuration de repos de la patte d'encliquetage 15 du premier élément 11B, qui est en pratique sa configuration de verrouillage, cette patte d'encliquetage 15 et les pattes d'encliquetage 19 du deuxième élément 11A s'étendent sensiblement dans un même plan N, en faisant volontairement abstraction de leur épaisseur.

Ce plan N est schématisé par sa trace sur la figure 4.

Il est sensiblement parallèle aux petits côtés du boîtier 11, et, donc, sensiblement perpendiculaire à la semelle 13 du deuxième élément 11A formant socle de celui-ci.

Les directions de pivotement P des pattes d'encliquetage 19 du deuxième élément 11A sont perpendiculaires à ce plan N.

En pratique, les pattes d'encliqu'etage 19 du deuxième élément 11A sont disposées latéralement par rapport à la patte d'encliquetage 15 du premier élément 11B et elles encadrent celle-ci.

Le cran de verrouillage 18 qu'elles portent intervient donc sur leur tranche.

Par contre, l'épaulement de retenue 20 qu'elles forment est constitué par l'un de leurs flancs, et, plus précisément, par leur flanc externe.

Préférentiellement, et cela est le cas dans la forme de réalisation représentée, la tranche des pattes d'encliquetage 19 du deuxième élément 11A est biseautée par un chanfrein 22 au droit de leur épaulement de retenue 20.

En pratique, de l'intérieur vers l'extérieur, ce chanfrein 22 fait un dièdre d'angle aigu avec l'épaulement de retenue 20.

Préférentiellement, également, et cela est également le cas dans la forme de réalisation représentée, la tranche de la patte d'encliquetage 15 du premier élément 11B est elle-même biseautée par un chanfrein 23 complémentaire du chanfrein 22 des pattes d'encliquetage 19 du deuxième élément 11A.

Pour la configuration de repos de la patte d'encliquetage 15 du premier élément 11B, et ainsi qu'il est représenté sur la figure 4, cette patte d'encliquetage 15 et les pattes d'encliquetage 19 du deuxième élément 11A sont en contact mutuel par leurs chanfreins 23, 22 respectifs.

Préférentiellement, et cela est le cas dans la forme de réalisation représentée, le premier élément 11B comporte, pour chacune des pattes d'encliquetage 19 du deuxième élément 11A, un retour 24 par lequel il contrebute cette patte d'encliquetage 19 du côté de l'épaulement de retenue 20 que forme celle-ci.

Préférentiellement, et cela est le cas dans la forme de réalisation représentée, la patte d'encliquetage 15 du premier élément 11B comporte des moyens d'intervention 25 propres à permettre d'exercer sur son extrémité libre une action de déverrouillage.

Dans la forme de réalisation représentée, ces moyens d'intervention 25 sont constitués par un ajour qui évide localement la patte d'encliquetage 15 entre son extrémité libre et sa racine.

Plus précisément, dans cette forme de réalisation, la patte d'encliquetage 15 du premier élément 11B comporte deux montants 26, et, à l'extrémité libre de ceux-ci, une traverse 27, qui, à ses propres extrémités, déborde latéralement de ces montants 26, en formant ainsi par elle-même les crans de verrouillage 16 correspondants, et qui délimite par ailleurs avec les montants 26 l'ajour constituant les moyens d'intervention 25.

Préférentiellement, et cela est le cas dans la forme de réalisation représentée, il est prévu, sur le premier élément 11B, du côté de celui-ci opposé à l'extrémité libre de sa patte d'encliquetage 15, une banquette d'appui 28, pour l'appui d'un quelconque outil d'intervention 30, par exemple la lame d'un tournevis, apte à faire levier.

Dans la forme de réalisation représentée, cette banquette d'appui 28 intervient au fond d'une encoche de guidage 31 propre au maintien de l'outil d'intervention 30.

Préférentiellement, enfin, et cela est le cas dans la forme de réalisation représentée, chacun des crans de verrouillage 16 de la patte d'encliquetage 15 du premier élément 11B est précédé par un chanfrein 32, et, de même, chacune des pattes d'encliquetage 19 du deuxième élément 11A comporte, en correspondance, un chanfrein 33 .

En pratique, pour chacune des pattes d'encliquetage 19, le chanfrein 33 recoupe le chanfrein 22, le long du bord libre de l'épaulement de retenue 20 correspondant.

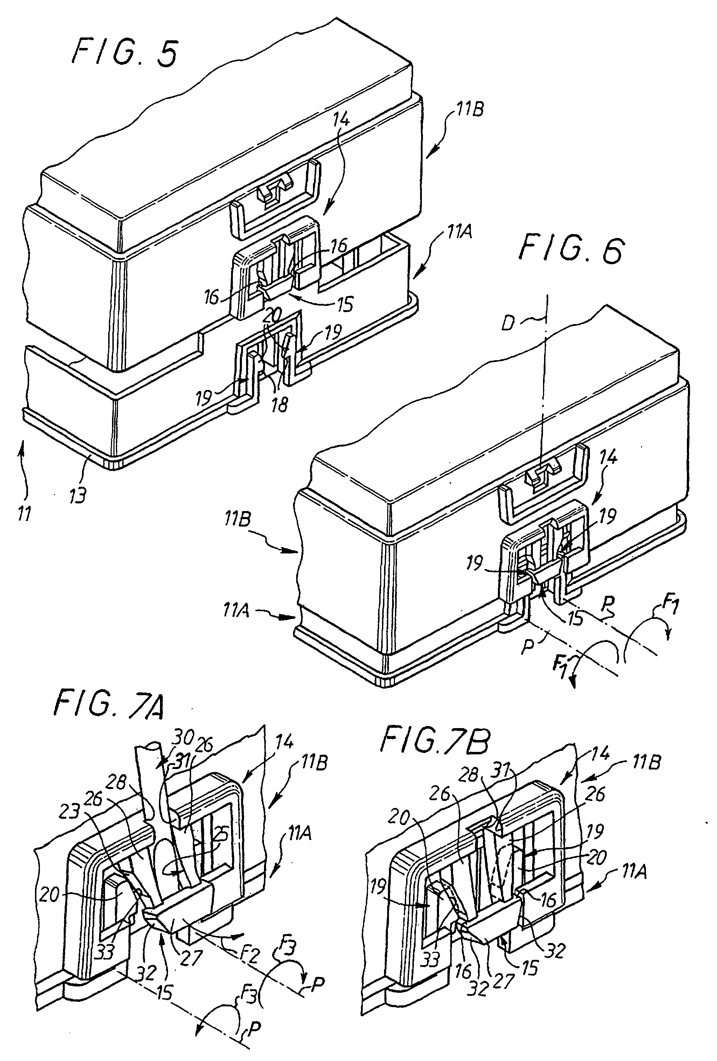

A la fermeture du boîtier 11, qui se fait suivant la direction d'emboîtement D, la patte d'encliquetage 15 du premier élément 11B de chacun des dispositifs de verrouillage 14 contraint ainsi temporairement les pattes d'encliquetage 19 du deuxième élément 11A à s'effacer élastiquement, par une déformation élastique de pivotement autour de leur direction de pivotement P, tel que schématisé par des flèches F1 sur la figure 6, jusqu'à ce que, tel que représenté sur les figures 2 et 3, ses crans de verrouillage 16 franchissant leur propre cran de verrouillage 18, elles puissent ainsi revenir à leur configuration initiale de verrouillage.

Pour cette configuration de verrouillage, la patte d'encliquetage 15 du premier élément 11B est dûment en prise avec les pattes d'encliquetage 19 du deuxième élément 11A, ses crans de verrouillage 16 étant crochetés sur leur propre cran de verrouillage 18, et le premier élément 11B est ainsi dûment attelé au deuxième élément 11A.

Pour l'ouverture du boîtier 11, il faut faire passer en configuration de déverrouillage la patte d'encliquetage 15 du premier élément 11B de chacun des dispositifs de verrouillage 14, en intervenant successivement sur chacun de ceux-ci.

Pour ce faire, et tel que représenté à la figure 7A pour l'un de ces dispositifs de verrouillage 14, il suffit d'insérer un outil d'intervention 30 derrière la traverse 27 de la patte d'encliquetage 15, à la faveur de l'ajour formant les moyens d'intervention 25 qu'elle comporte, puis, en faisant levier par cet outil d'intervention 30 en prenant appui sur la banquette d'appui 28 prévue à cet effet, d'exercer, de l'intérieur vers l'extérieur, une poussée sur la traverse 27, tel que schématisé par une flèche F2 sur la figure 7A.

La patte d'encliquetage 15 du premier élément 11B contraint alors temporairement les pattes d'encliquetage 19 du deuxième élément 11A à s'effacer élastiquement, par une déformation élastique de pivotement autour de leur direction de pivotement P, tel que schématisé par les flèches F3 sur la figure 7A, jusqu'à ce que, son flanc le plus interne franchissant leur propre épaulement de retenue 20, elles puissent, comme précédemment, revenir à leur configuration initiale de verrouillage.

Mais, par appui sur l'épaulement- de retenue 20 des pattes d'encliquetage 19 du deuxième élément 11A, la patte d'encliquetage 15 du premier élément 11B est empêchée, elle, de revenir à sa configuration initiale de verrouillage, et, au contraire, elle se trouve dès lors maintenue en configuration de déverrouillage, comme représenté sur la figure 7B.

Lorsqu'il en est ainsi pour l'un et l'autre des deux dispositifs de verrouillage 14, le premier élément 11B peut aisément être retiré d'une seul main du deuxième élément 11A, et la patte d'encliquetage 15 de chacun de ces deux dispositifs de verrouillage 14 revient alors d'elle-même à sa configuration de repos.

Ainsi qu'il est aisé de le comprendre, à la fermeture du boîtier 11, les chanfreins 32, 33 des pattes d'encliquetage 15, 19 facilitent l'effacement élastique des pattes d'encliquetage 19, et, par les chanfreins 23, 22, il en est de même à l'ouverture.

En outre, tant à la fermeture qu'à l'ouverture, les retours 24 du premier élément 11B assurent avantageusement un guidage des pattes d'encliquetage 19 du deuxième élément 11A, en contrebutant de surcroît avantageusement celles-ci à l'ouverture.

Bien entendu, la présente invention ne se limite pas à la forme de réalisation décrite et représentée, mais englobe toute variante d'exécution.

En outre, le domaine d'application de l'invention n'est pas limité aux boîtiers pour luminaires, ni même aux boîtiers pour appareils électriques, mais s'étend d'une manière plus générale à tous les boîtiers comportant deux éléments emboîtables l'un sur l'autre.

## Revendications

1. Boîtier comportant deux éléments (11A, 11B) emboîtables l'un sur l'autre suivant une direction d'emboîtement (D), à savoir :
- un premier élément (11A), comportant un moyen de verrouillage s'étendant sensiblement transversalement par rapport à la direction d'emboîtement (D), et
- un deuxième élément (11A) comportant au moins une patte d'encliquetage (19) munie d'au moins un cran de verrouillage (18) s'étendant sensiblement transversalement par rapport à la direction d'emboîtement (D) et adapté à coopérer en crochetage avec le moyen de verrouillage du premier élément (11B), la patte d'encliquetage (19) du deuxième élément (11A) étant élastiquement déformable autour d'une direction de pivotement (P) orthogonale à la direction d'emboîtement (D),
ledit boîtier étant **caractérisé en ce que** le dit moyen de verrouillage est un cran de verrouillage (16) appartenant à une patte d'encliquetage (15) apte à adopter une configuration déformée de déverrouillage dans laquelle son cran de verrouillage (16) est à l'écart du trajet du cran de verrouillage (18) de la patte d'encliquetage (19) du deuxième élément (11A), la patte d'encliquetage (19) du deuxième élément (11A) comportant un épaulement de retenue (20) apte à maintenir la patte d'encliquetage (15) du premier élément (11B) dans sa configuration déformée de déverrouillage.

2. Boîtier suivant la revendication 1, **caractérisé en ce que**, pour la configuration de repos de la patte d'encliquetage (15) du premier élément (11B), cette patte d'encliquetage (15) et la patte d'encliquetage (19) du deuxième élément (11A) s'étendent sensiblement dans un même plan (N).

3. Boîtier suivant l'une quelconque des revendications 1, 2, **caractérisé en ce que** la tranche de la patte d'encliquetage (19) du deuxième élément (11A) est biseautée par un chanfrein (22) au droit de son épaulement de retenue (20).

4. Boîtier suivant la revendication 3, **caractérisé en ce que** la tranche de la patte d'encliquetage (15) du premier élément (11B) est biseautée par un chanfrein (23) complémentaire du chanfrein (22) de la patte d'encliquetage (19) du deuxième élément (11A).

5. Boîtier suivant l'une quelconque des revendications 1 à 4, **caractérisé en ce que** le premier élément (11B) comporte un retour (24) par lequel il contrebute la patte d'encliquetage (19) du deuxième élément (11A) du côté de l'épaulement de retenue (20) que forme celle-ci.

6. Boîtier suivant l'une quelconque des revendications 1 à 5, **caractérisé en ce que** la patte d'encliquetage (15) du premier élément (11B) comporte, dos à dos, deux crans de verrouillage (16), et, en correspondance, le deuxième élément (11A) comporte deux pattes d'encliquetage (19), qui portent chacune un cran de verrouillage (18), et dont chacune forme un épaulement de retenue (20).

7. Boîtier suivant l'une quelconque des revendications 1 à 6, **caractérisé en ce que** la patte d'encliquetage (15) du premier élément (11B) comporte des moyens d'intervention (25) propres à permettre d'exercer sur son extrémité libre une action de déverrouillage.

8. Boîtier suivant la revendication 7, **caractérisé en ce que** les moyens d'intervention (25) sont constitués par un ajour qui évide localement la patte d'encliquetage (15) entre son extrémité libre et sa racine.

9. Boîtier suivant la revendication 8, **caractérisé en ce qu'**il est prévu, sur le premier élément (11B), du côté de celui-ci opposé à l'extrémité libre de sa patte d'encliquetage (15), une banquette d'appui (28), pour l'appui d'un quelconque outil d'intervention (30) apte à faire levier.

10. Boîtier suivant la revendication 9, **caractérisé en ce que** la banquette d'appui (28) intervient au fond d'une encoche de guidage (31).

11. Boîtier suivant l'une quelconque des revendications 6 à 10, **caractérisé en ce que** la patte d'encliquetage (15) du premier élément (11B) comporte deux montants (26), et, à l'extrémité libre de ceux-ci, une traverse (27), qui, à ses propres extrémités, forme les crans de verrouillage (16) correspondants.

12. Boîtier suivant l'une quelconque des revendications 1 à 11, **caractérisé en ce que** le deuxième élément (11A) est un élément formant socle et le premier élément (11B) est un élément formant couvercle.

## Patentansprüche

1. Gehäuse, bestehend aus zwei gemäß einer Steckrichtung (D) aufeinander steckbaren Elementen (11A,11B), und zwar:
- einem ersten Element (11B), das ein Verriegelungsmittel aufweist, das sich im wesentlichen quer bezüglich der Steckrichtung (D) erstreckt, und
- einem zweiten Element (11A), das mindestens einen Einklinklappen (19) aufweist, der mit mindestens einer Verriegelungsklinke (18) versehen ist, die sich im wesentlichen quer bezüglich der Steckrichtung (D) erstreckt und dafür ausgelegt ist, mit dem Verriegelungsmittel des ersten Elements (11B) verhakend zusammenzuwirken, wobei der Einklinklappen (19) des zweiten Elements (11A) um eine zur Steckrichtung (D) orthogonale Schwenkrichtung (P) elastisch verformbar ist,
wobei dieses Gehäuse **dadurch gekennzeichnet ist, dass** das Verriegelungsmittel eine Verriegelungsklinke (16) ist, die zu einem Einklinklappen (15) gehört, der eine verformte Entriegelungskonfiguration annehmen kann, in der seine Verriegelungsklinke (16) sich in einem Abstand von der Bewegungsbahn der Verriegelungsklinke (18) des Einklinklappens (19) des zweiten Elements (11A) befindet, wobei der Einklinklappen (19) des zweiten Elements (11A) eine Rückhalteschulter (20) aufweist, die den Einklinklappen (15) des ersten Elements (11B) in seiner verformten Entriegelungskonfiguration halten kann.

2. Gehäuse nach Anspruch 1, **dadurch gekennzeichnet, dass** der Einklinklappen (15) des ersten Elements (11B) und der Einklinklappen (19) des zweiten Elements (11A) sich in der Ruhekonfiguration des Einklinklappens (15) des ersten Elements (11A) im wesentlichen in einer gemeinsamen Ebene (N) erstrecken.

3. Gehäuse nach einem der Ansprüche 1, 2, **dadurch gekennzeichnet, dass** die Kante des Einklinklappens (19) des zweiten Elements (11A) auf Höhe seiner Rückhalteschulter (20) mit einer Abschrägung (22) versehen ist.

4. Gehäuse nach Anspruch 3, **dadurch gekennzeichnet, dass** die Kante des Einklinklappens (15) des ersten Elements (11B) mit einer Abschrägung (23) versehen ist, die zu der Abschrägung (22) des Einklinklappens (19) des zweiten Elements (11A) komplementär ist.

5. Gehäuse nach einem der Ansprüche 1 bis 4, **dadurch gekennzeichnet, dass** das erste Element (11B) eine Abwinklung (24) aufweist, mit der es den Einklinklappen (19) des zweiten Elements (11A) auf der Seite der Rückhalteschulter (20) abstützt, die dieser bildet.

6. Gehäuse nach einem der Ansprüche 1 bis 5, **dadurch gekennzeichnet, dass** der Einklinklappen (15) des ersten Elements (11B) Rücken an Rücken zwei Verriegelungsklinken (16) aufweist und das zweite Element (11A) in Entsprechung zwei Einklinklappen (19) aufweist, die jeweils eine Verriegelungsklinke (18) tragen und deren jeder eine Rückhalteschulter (20) bildet.

7. Gehäuse nach einem der Ansprüche 1 bis 6, **dadurch gekennzeichnet, dass** der Einklinklappen (15) des ersten Elements (11B) Interventionsmittel (25) aufweist, die dafür geeignet sind, die Ausübung einer Entriegelungswirkung auf sein freies Ende zu gestatten.

8. Gehäuse nach Anspruch 7, **dadurch gekennzeichnet, dass** die Interventionsmittel (25) von einem Durchbruch gebildet sind, der im Einklinklappen (15) zwischen seinem freien Ende und seiner Wurzel örtlich eine Aussparung bildet.

9. Gehäuse nach Anspruch 8, **dadurch gekennzeichnet, dass** auf dem ersten Element (11B) auf dessen Seite, die dem freien Ende seines Einklinklappens (15) entgegengesetzt ist, eine Auflagebank (28) für die Auflage eines beliebigen Interventionswerkzeugs (30), das einen Hebel bilden kann, vorgesehen ist.

10. Gehäuse nach Anspruch 9, **dadurch gekennzeichnet, dass** die Auflagebank (28) am Boden eines Führungsausschnitts (31) vorgesehen ist.

11. Gehäuse nach einem der Ansprüche 6 bis 10, **dadurch gekennzeichnet, dass** der Einklinklappen (15) des ersten Elements (11B) zwei Säulen (26) und am freien Ende von diesen einen Steg (27) aufweist, der an seinen eigenen Enden die entsprechenden Verriegelungsklinken (16) bildet.

12. Gehäuse nach einem der Ansprüche 1 bis 11, **dadurch gekennzeichnet, dass** das zweite Element (11A) ein einen Sokkel bildendes Element und das erste Element (11B) ein einen Deckel bildendes Element ist.

## Claims

1. A housing comprising two elements (11A, 11B) which are engageable one on to the other in an engagement direction (D), namely:
- a first element (11B) comprising a locking means extending substantially transversely with respect to the engagement direction (D), and
- a second element (11A) comprising at least one latching lug (19) provided with at least one locking catch (18) extending substantially transversely with respect to the engagement direction (D) and adapted to co-operate in hooking engagement with the locking means of the first element (11B), the latching lug (19) of the second element (11A) being elastically deformable about a pivot direction (P) which is orthogonal to the engagement direction (D),
the housing being **characterised in that** said locking means is a locking catch (16) belonging to a latching lug (15) capable of adopting a deformed unlocking configuration in which its locking catch (16) is disposed at a spacing from the path of movement of the locking catch (18) of the latching lug (19) of the second element (11A), the latching lug (19) of the second element (11A) comprising a retaining shoulder (20) capable of maintaining the latching lug (15) of the first element (11B) in its deformed unlocking configuration.

2. A housing according to claim 1 **characterised in that**, for the rest configuration of the latching lug (15) of the first element (11B), said latching lug (15) and the latching lug (19) of the second element (11A) extend substantially in the same plane (N).

3. A housing according to either one of claims 1 and 2 **characterised in that** the edge of the latching lug (19) of the second element (11A) is bevelled by a chamfer (22) in line with its retaining shoulder (20).

4. A housing according to claim 3 **characterised in that** the edge of the latching lug (15) of the first element (11B) is bevelled by a chamfer (23) complementary to the chamfer (22) of the latching lug (19) of the second element (11A).

5. A housing according to any one of claims 1 to 4 **characterised in that** the first element (11B) comprises a return portion (24) by way of which it supports the latching lug (19) of the second element (11A) on the side of the retaining shoulder (20) that same forms.

6. A housing according to any one of claims 1 to 5 **characterised in that** the latching lug (15) of the first element (11B) comprises in back-to-back relationship two locking catches (16) and in corresponding positions the second element (11A) comprises two latching lugs (19) which each carry a locking catch (18) and each of which forms a retaining shoulder (20).

7. A housing according to any one of claims 1 to 6 **characterised in that** the latching lug (15) of the first element (11B) comprises operational means (25) for permitting an unlocking action to be applied to its free end.

8. A housing according to claim 7 **characterised in that** the operational means (25) are formed by an opening which locally apertures the latching lug (15) between its free end and its root.

9. A housing according to claim 8 **characterised in that** provided on the first element (11B) on the side thereof which is opposite to the free end of the latching lug (15) is a support ledge (28) for supporting any operational tool (30) capable of acting as a lever.

10. A housing according to claim 9 **characterised in that** the support ledge (28) is operatively disposed at the bottom of a guide notch (31).

11. A housing according to any one of claims 6 to 10 **characterised in that** the latching lug (15) of the first element (11B) comprises two uprights (26) and, at the free end thereof, a transverse portion (27) which at its own ends forms the corresponding locking catches (16).

12. A housing according to any one of claims 1 to 11 **characterised in that** the second element (11A) is an element forming a base and the first element (11B) is an element forming a cover.
